# EUROPEAN PATENT APPLICATION

(11) **EP 4 733 251 A1**
(43) Date of publication of application: **29.04.2026**
(21) Application number: 24219360.5
(22) Date of filing: 12.12.2024
(51) Int. Cl.: C01B 19/00, H10N 10/852

(54) **CU, TE, AND S-BASED MATERIAL FOR THERMOELECTRIC CONVERSION AND METHOD OF PREPARATION THEREOF**

(30) Priority: 25.10.2024 PL 45013624
(71) Applicant: Akademia Gorniczo-Hutnicza im. Stanislawa Staszica w Krakowie, 30-059 Krakow (PL)
(72) Inventor: Cherniushok, Oleksandr, 30-065 Kraków (PL); Parashchuk, Taras, 31-221 Kraków (PL); Wojciechowski, Krzysztof, 32-082 Wieckowice (PL)
(74) Representative: Rogozinska, Alicja

(57) **Abstract**

The subject of the invention is a material based on Cu, Te and S for thermoelectric conversion having a γ-polymorphic modification of the β-tungsten type structure. The material according to the invention has a chemical formula Cu_{6+δ}Te₃₋ₓS₁₊ₓ, where 0 < x ≤ 1 and 0 ≤ δ ≤ 0.7. The invention refers also to a method for preparing of said material in which the elements Cu, Te, S are mixed in stoichiometric proportions, wherein the ratio of Cu : Te : S being respectively (6+δ):(3-x):(1+x), where 0 ≤ δ ≤ 0.7 and 0 < x ≤ 1, then the mixture is tightly sealed under vacuum in a quartz ampoule, followed by melting the elements mixture by heating to a temperature in the range from 1200 K to 1600 K, and annealing at this temperature for at least 5 hours to allow synthesis to take place in the liquid state, then a resulting ingot in the quartz ampoule is cooled down to room temperature and then it is grounded to a powder which is cold pressed and then the pressed powder is subjected to an annealing process by thermal treatment from 20 h to 1000 h at a temperature in the range of 700 K to 1000 K in vacuum or in protective atmosphere, after which it is cooled down to a room temperature resulting in an annealed material, that is later sintered with pressure by placing it in a graphite mold and heating it to temperatures in the range from 600 to 900 K under a pressure in the range from 20 to 200 MPa for a time ranging between 1 to 600 min, finally the resulting material is cooled down at a cooling rate ranging from 1 to 30 K/min.

## Description

### Field of the invention

The subject of the invention is a Cu, Te, and S-based material for thermoelectric conversion having the γ-polymorphic modification of the β-tungsten type structure. The invention also relates to a method for its preparation.

### Background Art

In commonly produced thermoelectric modules, thermoelectric materials based on Bi₂Te₃ alloys are used. However, the efficiency of commercial thermoelectric modules based on these alloys is low, reaching only 5-6%, which significantly limits their application range for energy conversion.

New materials with better thermoelectric properties are currently being developed, including materials with a filled β-tungsten-type structure, also known as materials of the Cr₃Si-or A15-type. Compounds with the general chemical formula Cu₆(Te,S)₄ also crystallize in this structure. However, these materials exhibit various substructures (so-called polymorphic modifications), such as α, β, and γ, with different temperature ranges of stability. The change in structure type is called a phase transition and is usually associated with a deterioration in the mechanical and thermoelectric properties of the materials. Therefore, phase transitions within the operating temperature range of thermoelectric converters are unfavourable. For materials with the composition Cu_{6+δ}Te₃₋ₓS₁₊ₓ, when x ≤ 0, the phase transformation from α to β occurs at temperatures above room temperature, which significantly limits the application range of materials with this chemical composition. However, the γ-phase, existing in compositional range 0 < x ≤ 1, is stable from room temperature to 800 K, making it the most favorable for energy conversion.

For example, in the publications Giller, M., Grotz, C., Rudyk, B., Mar, A., & Nilges, T. (2014). Cu6Te3S - a Cu-filled Cr3Si-structure variant. Zeitschrift für Kristallographie - Crystalline Materials, 229(12), 831-839. https://doi.org/10.1515/zkri-2014-1797 and Liu, Z., Zhang, W., Gao, W., & Mori, T. (2021). A material catalogue with glass-like thermal conductivity mediated by crystallographic occupancy for thermoelectric application. Energy & Environmental Science, 14(6), 3579-3587. https://doi.org/10.1039/D1EE00738F, the material Cu₆Te₃S and its preparation method were disclosed. These materials undergo an unfavorable phase transition from the α structure to the β structure (*P*2₁3 and P-43n space groups, respectively) and do not contain a thermodynamically stable γ-phase. Moreover, the compound Cu₆Te₃S has metallic character, which results in relatively low thermoelectric energy conversion efficiency.

In the publication Rabenbauer, A., Vogel, A., Venturini, J., Moslemi, M., Oeckler, O., Daisenberger, D., & Nilges, T. (2023). Cu1.5SeyTe1-y (y = 0.2-0.7): A Series of Narrow Band Gap Semiconductors with Low Thermal Conductivity at Ambient Temperature. Inorganic Chemistry, 62(31), 12600-12610. https://doi.org/10.1021/acs.inorgchem.3c02037, the preparation method for Cu_{1.5}Se_{y}Te_{1-y} (y = 0.2-0.7) or Cu₆Se_{y}Te_{4-y} (y = 0.8-2.8) materials with a structure of β-tungsten type was disclosed. However, these materials show low thermoelectric performance with a ZT parameter < 0.2 at 573 K and are thermally unstable.

In the publications He, Y., Lu, P., Shi, X., Xu, F., Zhang, T., Snyder, G. J., & Chen, L. (2015). Ultrahigh thermoelectric performance in mosaic crystals. Advanced Materials, 27(24), 3639-3644. https://doi.org/10.1002/adma.201501030 and Su, H., Lu, P., Zhu, C., Qiu, W., Qiu, X., Zhao, K., & Xu, F. (2023). Compositionally tailored order-disorder of cation-anion sublattices in Cu2Te1-xSx solid solution thermoelectric materials. Acta Materialia, 248, 118764. https://doi.org/10.1016/j.actamat.2023.118764, the preparation method of Cu₂Te₁₋ₓSₓ materials with a hexagonal structure but not a β-tungsten structure was disclosed.

In patent application CN103872237A, a Cu₂₋ₓS_{1-y}A_{y} type thermoelectric material (for example, Cu₂₋ₓS and Cu₂₋ₓS_{1-y}A_{y}, where A is Se or Te) and its preparation method are disclosed. This material with the composition Cu₂₋ₓS_{1-y}(Se/Te)_{y}, where x ranges from 0.02 to 0.05 and y ranges from 0.2 to 0.4, has a chalcocite structure. The thermoelectric performance (ZT parameter) of these materials can reach 1 or higher at 800 K, but they are thermally unstable in this temperature range and do not exhibit repeatable thermoelectric properties.

Patent application CN105990510A discloses a high-efficiency thermoelectric material for thermoelectric applications, with the general chemical formula Cu₂Se₁₋ₓSₓ, where 0 ≤ x ≤ 0.16. The disclosed thermoelectric material shows high energy conversion efficiency but only at high temperatures, where it exhibits limited chemical composition stability. Furthermore, this material undergoes phase transitions in the temperature range of 300-800 K, leading to degradation of its microstructure and, consequently, a loss of its mechanical and thermoelectric properties.

Patent application CN102674842A discloses a thermoelectric material based on the chemical formula Cu_{1.8}S₁₋ₓSeₓ, where 0.01 ≤ x ≤ 0.99, and its preparation method. The material is synthesized by mechanical alloying and formed using the spark plasma sintering (SPS) method. This method enables the simple and rapid production of Cu-S-Se thermoelectric material, which exhibits relatively good thermoelectric properties in the mid-temperature range. However, the use of this method results in the production of a non-homogeneous material containing large amounts of impurities. Moreover, obtaining repeatable thermoelectric properties for materials synthesized by the method described in CN102674842A is problematic.

### Technical problem

The objective of this solution is to develop a material based on Cu, Te, and S for thermoelectric conversion, exhibiting high thermoelectric energy conversion efficiency greater than 10%. Additionally, the material should demonstrate high thermal stability over a wide temperature range and not undergo phase transitions within the operating temperature range of thermoelectric converters made from it.

The resulting material is intended for a wide range of applications, especially for the production of thermoelectric converters for waste heat recovery, solar and geothermal energy conversion, and thermoelectric cooling (Peltier modules).

This material should be produced from relatively inexpensive and non-toxic elements in a technological process that does not require the use of environmentally hazardous solvents and chemical compounds.

### Summary of the Invention

A material based on Cu, Te and S for thermoelectric conversion having a γ-polymorphic modification of a β-tungsten type structure, according to the invention has a chemical formula Cu_{6+δ}Te₃₋ₓS₁₊ₓ, where 0 < x ≤ 1 and 0 ≤ δ ≤ 0.7.

Advantageously, the material according to the invention has the chemical formula Cu₆Te_{2.3}S_{1.7}.

A method for preparation of the material based on Cu, Te and S for thermoelectric conversion having a γ-polymorphic modification of the β-tungsten type structure according to the invention is characterized by the fact that the elements Cu, Te, S are mixed in stoichiometric proportions, wherein the ratio of Cu : Te : S being respectively (6+δ):(3-x):(1+x), where 0 ≤ δ ≤ 0.7 and 0 < x ≤ 1, then the mixture is tightly sealed under vacuum in a quartz ampoule, followed by melting the elements mixture by heating to a temperature in the range from 1200 K to 1600 K, and annealing at this temperature for at least 5 hours to allow synthesis to take place in the liquid state, then a resulting ingot in the quartz ampoule is cooled down to room temperature and then it is grounded to a powder which is cold pressed and then the pressed powder is subjected to an annealing process by thermal treatment from 20 h to 1000 h at a temperature in the range of 700 K to 1000 K in vacuum or in protective atmosphere, after which it is cooled down to a room temperature resulting in an annealed material, that is later sintered with pressure by placing it in a graphite mold and heating it to temperatures in the range from 600 to 900 K under a pressure in the range from 20 to 200 MPa for a time ranging between 1 to 600 min, finally the resulting material is cooled down at a cooling rate ranging from 1 to 30 K/min.

Advantageously, the quartz ampoule coated on the inside with graphite is used during the synthesis reaction in the liquid state.

Advantageously, the sintering with pressure of the annealed material is carried out using a spark plasma sintering (SPS) method.

Unlike the aforementioned materials, the material according to the invention with the composition Cu_{6+δ}Te₃₋ₓS₁₋ₓ and the γ-polymorphic modification of the β-tungsten-type structure is thermally stable and does not undergo phase transitions, maintaining good thermoelectric and mechanical properties over a wide temperature range.

By optimizing the composition and synthesis conditions, the γ-phase (space group 1-43d) of the *β*-tungsten-type structure Cu_{6+δ}Te₃₋ₓS_{1+*x*}, of advantageous thermoelectric properties. By introducing an appropriate excess of Cu, an optimal carrier concentration is achieved, and by adjusting the Te/S ratio, a favourable energy bandgap (*E_{g}*) is obtained. The material according to the invention, due to the replacement of tellurium with sulphur in properly selected proportions, is a semiconductor with a narrow bandgap. The simultaneous use of both factors improves the thermoelectric power factor (PF) of this material in the temperature range from 298 K to 673 K and enables the achievement of a high energy conversion efficiency (η) of around 11%.

The introduction of sulphur in place of tellurium in Cu_{6+δ}Te_{3-*x*}S_{1+*x*} (0 ≤ *x* ≤ 1, 0 ≤ δ ≤ 0.7) leads to the formation of a thermodynamically stable γ-polymorphic modification (space group *I*-4*3d*) in the temperature range from approximately 300 K to 700 K. Therefore, this material does not undergo unfavourable phase transitions and maintains good mechanical and thermoelectric properties within this temperature range.

Partial replacement of harmful and expensive tellurium with easily available and less toxic sulphur enables the production of more environmentally friendly and cheaper thermoelectric converters for common applications (e.g., waste heat recovery, solar and geothermal energy conversion, thermoelectric cooling).

### Brief Description of Drawing

The subject of the invention is illustrated in the embodiments shown in the drawing, where:
Fig. 1 shows X-ray diffraction (XRD) patterns of materials with the composition Cu_{6+δ}Te₃₋ₓS₁₊ₓ, describing the crystal structure of the γ-phase (space group *I*-43*d*);
Fig. 2 shows DSC curves of Cu_{6+δ}Te_{3-*x*}S_{1+*x*} samples, highlighting the temperature ranges for the occurrence of polymorphic modifications α, β, and y;
Fig. 3 shows Scanning electron microscope (SEM) image showing the microstructure of the Cu₆Te_{2.3}S_{1.7}, material, obtained using the method according to the invention, and
Fig. 4 shows graph comparing the thermoelectric efficiency η as a function of the temperature difference ΔT for materials with Cu_{6+δ}Te₃₋ₓS ₁₊ₓ compositions from the prior art and according to the invention.

### Description of Embodiments

The subject of the invention is a copper-tellurium-sulphur material for thermoelectric conversion with the γ-polymorphic modification of the *β*-tungsten type structure, characterized by a chemical formula Cu_{6+δ}Te_{3-*x*}S_{1+*x*}, where 0 < x ≤ 1 and 0 ≤ δ ≤ 0.7. In the preferable embodiment the material has the chemical formula Cu₆Te_{2.3}S_{1.7}.

The material according to the invention was obtained by a method in which the elements Cu, Te, and S with a purity of over 99.99% were first weighed and mixed together in stoichiometric proportions according to the chemical formula of Cu_{6+δ}Te₃₋ₓS₁₊ₓ, where 0 < x < 1 and 0 ≤ δ ≤ 0.7, then they were hermetically sealed under 10⁻⁵ mbar vacuum in quartz ampoules. Sealed ampoules were placed in high temperature furnace and heated to temperature of 1373 K for 10 hours, and then annealed in said temperature for 10 hours. This heat treatment process allows for the synthesis reaction to take place in the liquid state. After synthesis, the quartz ampoules were cooled inertially to room temperature.

In the embodiment of the method for obtaining a material with the chemical formula Cu_{6+δ}Te₃₋ₓS₁₊ₓ, where 0 < x ≤ 1 and 0 ≤ δ ≤ 0.7, during the heat treatment, quartz ampoules coated on the inside with a graphite layer were advantageously used. During the heat treatment process, the material in the liquid state may react with quartz, and the graphite coating of the quartz ampoule prevents such a reaction and prevents the material from melting onto the walls of the quartz ampoule.

The product of the synthesis was ground into a powder, which was then cold-pressed. The pressed material was subjected to further thermal treatment by annealing for 150 hours at a temperature of 873 K in quartz ampoules under vacuum to obtain a homogeneous material. The annealed material was then cooled inertially to room temperature.

The cooled material was ground into a powder, then sintered in a graphite mold by heating to a temperature in the range of 600 to 900 K and applying pressure in the range of 20 to 200 MPa for a time period of 1 to 600 minutes to form a sinter. The resulting sinter was subjected to slow cooling at a rate of 1 to 30 K/min.

In the example of the method for obtaining a material with the chemical formula Cu_{6+δ}Te₃₋ₓS_{1+*x*}, where 0 < x < 1 and 0 ≤ δ ≤ 0.7, sintering was carried out using the spark plasma sintering (SPS) technique, heating the material at a rate of 70 K/min to 723 K under a pressure of 45 MPa, followed by annealing at 723 K for 30 minutes in an argon atmosphere. Finally, the processed material was cooled at a rate of 20 K/min. Other sintering techniques can also be used to obtain the material, such as conventional sintering (sintering in a furnace) or hot pressing in a protective atmosphere.

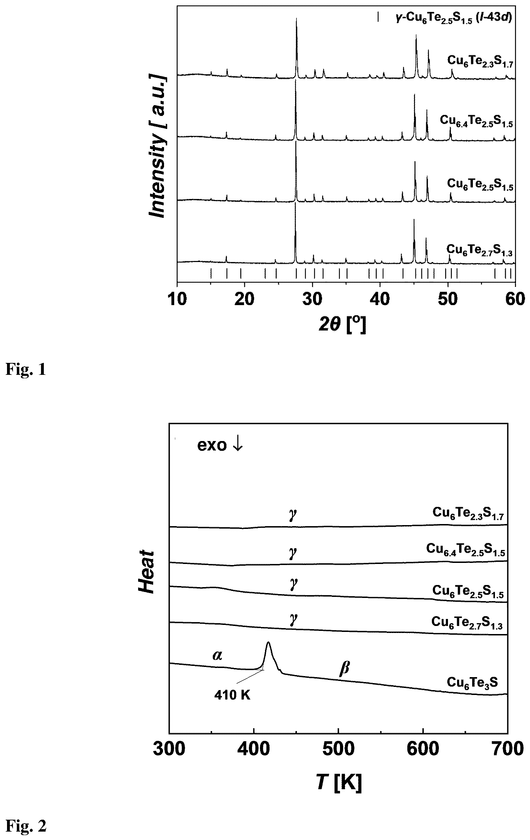

The material according to the invention is characterized by the γ-polymorphic modification (space group 1-43d), resulting from its chemical composition Cu_{6+δ}Te₃₋ₓS_{1+*x*}, where 0 < x ≤ 1 a 0 ≤ δ ≤ 0.7. Fig. 1 shows X-Ray Diffraction (XRD) patterns for materials with the chemical formula Cu_{6+δ}Te_{3-*x*}S_{1+*x*} that have different sulphur and tellurium contents. The introduction of sulphur in place of tellurium in the compound with the chemical formula Cu_{6+δ}Te_{3-*x*}S_{1+*x*} (0 < *x* ≤ 1 a 0 ≤ δ ≤ 0.7) stabilizes the favourable γ-polymorphic modification (space group *I*-4*3d*) at room temperature, as confirmed by X-ray diffraction (XRD) and differential scanning calorimetry (DSC) methods.

If the chemical composition is not maintained according to the chemical formula Cu_{6+δ}Te₃₋ₓS₁₊ₓ, where 0 < x < 1 and 0 ≤ δ ≤ 0.7 then the α-polymorphic modification, which then undergoes a phase transition to β at 410 K, as shown on the exemplary DSC curve (Fig. 2) for the material with the composition Cu₆Te₃S (for x = 0, δ = 0). Partial replacement of tellurium with sulphur leads to the formation of the γ-polymorphic modification and completely eliminates phase transitions in the temperature range from 300 K to 700 K. This is a very important result from the perspective of the practical application of the obtained materials for thermoelectric energy conversion, as any structural transitions within the operating temperature range of thermoelectric converters cause degradation of the microstructure and deterioration of the materials mechanical and thermoelectric properties.

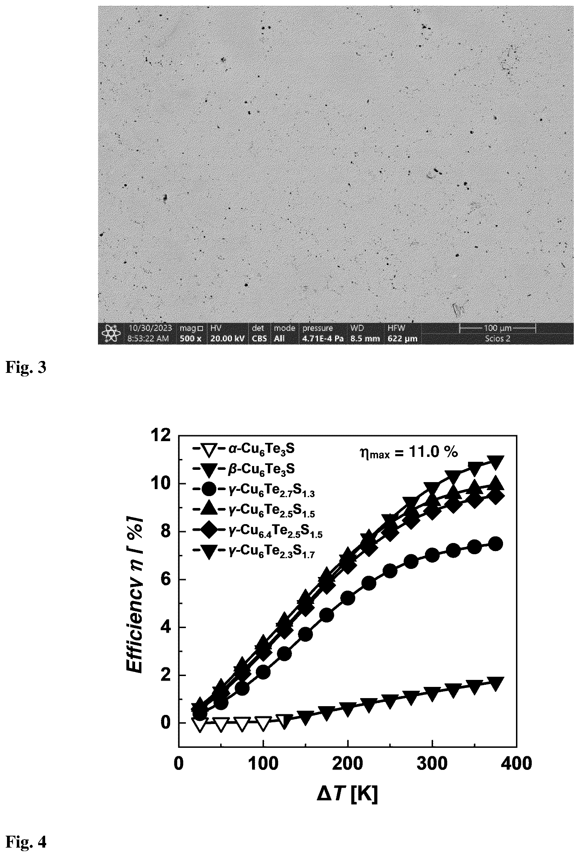

Fig. 3 shows a representative image from a scanning electron microscope (SEM) of the material with the composition Cu₆Te_{2.3}S_{1.7} obtained after sintering. The image demonstrates the high uniformity of the materials microstructure and its good densification, i.e., low porosity. The favourable microstructure and low porosity of the material are achieved by ensuring the appropriate parameters in the method of materials production according to the invention.

Replacing tellurium with sulphur in comparison to materials currently known and used alters the electronic structure, leading to the opening of the forbidden gap in the materials and resulting in semiconducting properties.

The obtained materials with the composition Cu_{6+δ}Te_{3-*x*}S_{1+*x*} (0 < x ≤ 1 and 0 ≤ δ ≤ 0.7) have a significantly higher thermoelectric power factor (PF) and significantly lower thermal conductivity compared to the known compound Cu₆Te₃S.

The introduction of sulphur in place of tellurium in the compound with the formula Cu_{6+δ}Te_{3-*x*}S_{1+*x*} (0 < x ≤ 1 a 0 ≤ δ ≤ 0.7) allows for a significant increase in efficiency up to 11% compared to the known prior art Cu₆Te₃S, that has efficiency of 1.7% for ΔT = 375 K, (Fig. 4).

The thermoelectric materials developed according to the invention are made from copper (Cu), tellurium (Te), and sulphur (S), which are elements that are relatively harmless to the environment and inexpensive, making them suitable for the production of thermoelectric converters for common applications (e.g., waste heat recovery, solar and geothermal energy conversion, thermoelectric cooling).

## Claims

1. Material based on Cu, Te and S for thermoelectric conversion having a γ-polymorphic modification of a β-tungsten type structure, **characterized by** a chemical formula Cu_{6+δ}Te₃₋ₓS₁₊ₓ, where 0 < x ≤ 1 and 0 ≤ δ ≤ 0.7.

2. Material according to claim 1, **characterized by** the chemical formula Cu₆Te_{2.3}S_{1.7}.

3. Method for preparation of the material based on Cu, Te and S for thermoelectric conversion having a γ-polymorphic modification of the β-tungsten type structure according to claim 1 or 2, **characterized in that** the elements Cu, Te, S are mixed in stoichiometric proportions, wherein the ratio of Cu : Te : S being respectively (6+δ):(3-x):(1+x), where 0 ≤ δ ≤ 0.7 and 0 < x ≤ 1, then the mixture is tightly sealed under vacuum in a quartz ampoule, followed by melting the elements mixture by heating to a temperature in the range from 1200 K to 1600 K, and annealing at this temperature for at least 5 hours to allow synthesis to take place in the liquid state, then a resulting ingot in the quartz ampoule is cooled down to room temperature and then it is grounded to a powder which is cold pressed and then the pressed powder is subjected to an annealing process by thermal treatment from 20 h to 1000 h at a temperature in the range of 700 K to 1000 K in vacuum or in protective atmosphere, after which it is cooled down to a room temperature resulting in an annealed material, that is later sintered with pressure by placing it in a graphite mold and heating it to temperatures in the range from 600 to 900 K under a pressure in the range from 20 to 200 MPa for a time ranging between 1 to 600 min, finally the resulting material is cooled down at a cooling rate ranging from 1 to 30 K/min.

4. Method according to claim 3, **characterized in that** the quartz ampoule coated on the inside with graphite is used during the synthesis reaction in the liquid state.

5. Method according to claim 3 or 4, **characterized in that** the sintering with pressure of the annealed material is carried out using a spark plasma sintering (SPS) method.
